(19) Europäisches Patentamt
European Patent Office
Office européen des brevets

(11) EP 4 407 332 A1

(12) **EUROPEAN PATENT APPLICATION**
published in accordance with Art. 153(4) EPC

(43) Date of publication:
**31.07.2024 Bulletin 2024/31**

(21) Application number: **22873113.9**

(22) Date of filing: **24.08.2022**

(51) International Patent Classification (IPC):
***G01R 31/389** (2019.01)* ***G01R 31/392** (2019.01)*
***G01R 31/3842** (2019.01)* ***G01R 27/08** (2006.01)*
***H01M 10/48** (2006.01)*

(52) Cooperative Patent Classification (CPC):
**G01R 27/08; G01R 31/3842; G01R 31/389; G01R 31/392; H01M 10/48;** Y02E 60/10

(86) International application number:
**PCT/KR2022/012659**

(87) International publication number:
**WO 2023/048408 (30.03.2023 Gazette 2023/13)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **24.09.2021 KR 20210126713**
**22.08.2022 KR 20220104918**

(71) Applicant: **Techwin Co., Ltd.**
**Cheongju-si, Chungcheongbuk-do 28580 (KR)**

(72) Inventors:
- **JUNG, Boong Ik**
  **Cheongju-si, Chungcheongbuk-do 28582 (KR)**
- **JUNG, In Seok**
  **Cheongju-si, Chungcheongbuk-do 28425 (KR)**
- **OH, Seung Chan**
  **Daejeon 34379 (KR)**
- **LIM, Gun Pyo**
  **Daejeon 34083 (KR)**

(74) Representative: **Moosedog Oy**
**Vähäheikkiläntie 56C**
**20810 Turku (FI)**

(54) **REAL-TIME BATTERY MONITORING APPARATUS AND METHOD USING TRANSIENT RESPONSE ANALYSIS**

(57) Provided are a real-time battery monitoring apparatus and method using transient response analysis. The real-time battery monitoring apparatus includes a monitoring circuit connected to a battery and a processor configured to determine deterioration of the battery by controlling the monitoring circuit to measure a voltage and a current of the battery, estimate an internal resistance of the battery based on the measured voltage and current, and compare the estimated internal resistance with a pre-set threshold value.

FIG. 3

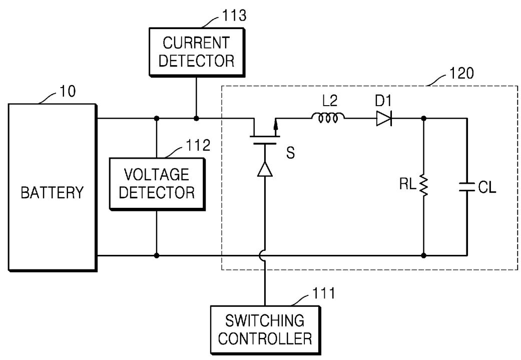


EP 4 407 332 A1

## Description

Technical Field

Embodiments relate to a real-time battery monitoring apparatus and method using transient response analysis.

Background Art

The internal resistance of a secondary battery may increase according to the degree of deterioration, which may cause a capacity loss of the secondary battery and an increase in internal heat during use. Such a phenomenon may be directly caused by thermal stress, and the deterioration progresses gradually according to the number of repeated uses. An accident leading to fire due to a thermal runaway phenomenon, for example, energy storage system (ESS) fire, electric vehicle fire, or the like, frequently occurs according to circumstances. Accordingly, various technologies for pre-detecting and preventing the deterioration and occurrence of the thermal runaway phenomenon of a battery have been proposed.

An internal resistance measurement method of the prior art measures an impedance through repeated charging and discharging operations for an entire state of charge (SOC) period. An open circuit voltage (OCV) in an idle state and a voltage that increases and decreases during charging and discharging are measured. The internal resistance of a secondary battery varies for each SOC due to electrochemical reasons, and thus, it is required to measure the internal resistance in a section between a charge limit voltage and a discharge limit voltage of the secondary battery. Thus, to measure the entire section, separate charging and discharging control is required for the measurement and it is not possible to use the secondary battery during the measurement.

Electrochemical impedance spectroscopy (EIS) is a method of measuring an impedance by measuring a change in an output according to a variable frequency input and projecting the same onto a Nyquist diagram, and the degree of deterioration is determined by measuring the internal resistance of a battery. It is possible to precisely measure an alternating current (AC) and direct current (DC) impedance and determine the degree of deterioration in a normal state. However, a measurement time is somewhat long from several seconds to several minutes, a complex calculation process with a frequency control input circuit for frequency measurement and spectrum analysis is required, a control circuit is complicated, miniaturization is difficult, and costs are high.

An off-gas detection method detects a situation where a gas is generated inside a secondary battery while the secondary battery reaches a thermal runaway situation, a swelling phenomenon occurs, i.e., the secondary battery swells, and then the internal gas is externally discharged and blocks a battery connection, thereby preventing a fire. The off-gas detection method is a method of installing a sensor around the secondary battery for the detection to detect and block a physical phenomenon that occurs before a fire. However, undetected cases may occur depending on a structure of internal air circulation, an installation cost is high, and it is impossible to determine the degree of deterioration in a normal state.

Disclosure

Technical Problem

Provided are a real-time battery monitoring apparatus and method using transient response analysis, wherein a circuit is simple and measurement is possible even in a charging and discharging condition, compared to electrochemical impedance spectroscopy (EIS) of the prior art, by analyzing a response characteristic, i.e., a current/voltage response pattern, for a temporary transient state condition of a battery output.

Also, the measurement is possible regardless of a charging/discharging/idle state of a battery, and a time required for the measurement is one ten thousandths of a second (100 usec), and thus, a measurement time and power consumption required for impedance measurement may be minimized.

In addition, it is possible to diagnose a deterioration state by analyzing changes in real time during an operation of each secondary battery or a battery.

Technical Solution

A real-time battery monitoring apparatus using transient response analysis, according to an embodiment, includes a monitoring circuit connected to a battery, and a processor configured to determine deterioration of the battery by controlling the monitoring circuit to measure a voltage and a current of the battery, estimate an internal resistance of the battery, based on the measured voltage and current, and compare the estimated internal resistance with a pre-set threshold value.

The monitoring circuit may include a switch device connected to one end of the battery, an inductor connected in series to one end of the switch device, a diode connected in series to the inductor, a capacitor connected in series to the diode, and a resistor connected in parallel to the capacitor.

The processor may be further configured to, so as to analyze a response characteristic of the battery while charging the capacitor in a discharge state with an output of the battery, discharge, by turning off the switch device, a voltage charged in the capacitor through the resistor, charge the capacitor with power of the battery by turning on the switch device after a lapse of a predetermined time, and measure the current and the voltage of the battery during a period of charging.

The processor may be further configured to estimate the internal resistance of the battery, based on changes in a peak value of the current and a peak value of the voltage, normalize the internal resistance according to equation [Equation] $R_{Normal}(\mathrm{OCV}) - \frac{\Delta V_{PEAK(OCV)}}{I_{PEAK(OCV)}}$, and when the normalized internal resistance is outside the threshold value, determine that the battery is deteriorated.

A switching time including on and off of the switch may be within several msec.

A control method for a real-time battery monitoring apparatus including a monitoring circuit connected to a battery, according to another embodiment, includes measuring a voltage and a current of the battery by controlling the monitoring circuit, estimating an internal resistance of the battery, based on the measured voltage and current, and determining deterioration of the battery by comparing the estimated internal resistance with a pre-set threshold value.

The measuring may include discharging, by turning off a switch device of the monitoring circuit, a voltage charged in a capacitor of the monitoring circuit through a resistor, charging the capacitor with power of the battery by turning on the switch device after a lapse of a predetermined time, and measuring the current and the voltage of the battery during a period of charging.

The control method may further include estimating the internal resistance of the battery, based on changes in a peak value of the current and a peak value of the voltage, normalizing the internal resistance according to equation [Equation] $R_{Normal}(\mathrm{OCV}) = \frac{\Delta V_{PEAK(OCV)}}{I_{PEAK(OCV)}}$, and when the normalized internal resistance is outside the threshold value, determining that the battery is deteriorated.

A switching time including on and off of the switch may be within several msec.

A computer-readable recording medium according to another embodiment has recorded thereon a program for executing, on a computer, the control method for a real-time battery monitoring apparatus.

Advantageous Effects

A battery monitoring apparatus and method using transient response analysis, according to an embodiment, analyzes a response characteristic, i.e., a current/voltage response pattern, for a temporary transient state condition of a battery output, and thus, a circuit is simple and measurement is possible even in a charging/discharging condition, compared to electrochemical impedance spectroscopy (EIS) of the prior art.

Also, the measurement is possible regardless of a charging/discharging/idle state of a battery, and a time required for the measurement is about one ten thousandths of a second (100 usec), and thus, a measurement time and power consumption required for impedance measurement may be minimized.

In addition, it is possible to diagnose a deterioration state by analyzing changes in real time during an operation of each secondary battery.

Description of Drawings

FIG. 1 is a schematic diagram of a battery monitoring apparatus 100 according to an embodiment.

FIG. 2 is a detailed schematic diagram of the battery monitoring apparatus 100 of FIG. 1.

FIG. 3 is a circuit diagram for describing the battery monitoring apparatus 100 according to another embodiment.

FIGS. 4 to 6 illustrate examples of analyzing a transient response characteristic of a battery shown in FIG. 3.

FIG. 7 is a circuit diagram for describing the battery monitoring apparatus 100 according to another embodiment.

FIGS. 8 to 12 are diagrams showing simulation results for describing a battery internal resistance.

Mode for Invention

Hereinafter, embodiments will be described in detail with reference to accompanying drawings. Embodiments described below are only examples and various modifications may be made from such embodiments. In the drawings, like reference numerals denote like elements and the sizes of the elements may be exaggerated for clarity and convenience of description.

The terms used in the specification will be briefly defined, and the present disclosure will be described in detail.

All terms including descriptive or technical terms which are used herein should be construed as having meanings that are obvious to one of ordinary skill in the art. However, the terms may have different meanings according to the intention of one of ordinary skill in the art, precedent cases, or the appearance of new technologies. Also, some terms may be arbitrarily selected by the applicant, and in this case, the meaning of the selected terms will be described in detail in the detailed description of the present disclosure. Thus, the terms used herein have to be defined based on the meaning of the terms together with the description throughout the specification.

When a part "includes" or "comprises" an element, unless there is a particular description contrary thereto, the part may further include other elements, not excluding the other elements. In addition, terms such as "unit", "-or/-er", and "module" described in the specification denote a unit that processes at least one function or operation, which may be implemented in hardware or software, or implemented in a combination of hardware and software.

According to an embodiment, a battery may denote a rechargeable secondary battery, for example, a lithium ion battery. According to an embodiment, the term "battery" or "secondary battery" are used in a same meaning.

According to an embodiment, a battery may be a cell used for an energy storage system (ESS). The ESS refers to an apparatus that stores electrical energy generated by frequency adjustment for frequency stability of a power system, thermal power or nuclear power, or renewable energy generation using solar and wind power, and is used when necessary. The ESS includes a battery, a battery management system (BMS), a power conversion system (PCS), and a power management system (PMS) that is operating software. The battery stores electrical energy in the form of chemical energy. The BMS may be divided into a cell (or module) BMS that controls individual battery cells and a pack BMS that manages and controls a battery pack in general.

According to an embodiment, a real-time battery monitoring apparatus may operate as a functional module by interworking with the ESS or in the ESS. Also, the real-time battery monitoring apparatus may be realized by interworking with the BMS or being combined to the BMS, as a circuit functional module of the BMS.

According to an embodiment, the real-time battery monitoring apparatus may be applied to not only the ESS described above, but also any application that uses a secondary battery or a battery, such as an electric vehicle, a drone, an industrial mobile robot, or a service mobile robot.

According to an embodiment, an intermittent current interruption (ICI) method is improved to analyze aging behavior of a commercial lithium ion battery. According to an ICI method of the prior art, artificially determined charging or discharging control processes are performed at a time point to be measured, so as to measure internal impedance of a battery. Accordingly, to apply the ICI method, the battery is unable to be used for a normal purpose in an actual system. A circuit model of a battery monitoring apparatus according to an embodiment measures an instantaneous change in a battery output by connecting a battery output line to a discharged capacitor load through an on-off control circuit. The measurement is performed quicker than the existing ICI method, without having to perform disconnection control for the measurement, and thus, the improved ICI method is suitable for real-time online monitoring. Also, an implementation circuit is very simple, and thus, costs may be minimized.

According to an embodiment, it is identified that the improved ICI method is a very effective method, through simulation analysis to which a battery equivalent circuit model is applied and an actual measurement test result for a commercial battery module.

FIG. 1 is a schematic diagram of a battery monitoring apparatus 100 according to an embodiment. FIG. 2 is a detailed schematic diagram of the battery monitoring apparatus 100 of FIG. 1.

Referring to FIGS. 1 and 2, the battery monitoring apparatus 100 is connected to a battery 10. The battery monitoring apparatus 100 may be a partial functional module of an ESS or a partial functional module of a BMS. The battery monitoring apparatus 100 controls a monitoring circuit 120 to measure a voltage and current of the battery 10 and estimate an internal resistance of the battery 10 based on the measured voltage and current. Also, the battery monitoring apparatus 100 includes a processor 110 that compares the estimated internal resistance with a pre-set threshold value and determines deterioration of the battery 10.

The processor 110 includes a switching controller 111, a voltage detector 112, a current detector 113, and a deterioration determiner 114. The switching controller 111 controls on/off of a switch connected between the battery 10 and the monitoring circuit 120. The voltage detector 112 measures an output voltage of the battery 10 or a change in the output voltage when the switch is turned on/off. The current detector 113 measures an output current of the battery 10 or a peak value of the output current when the switch is turned on. The deterioration determiner 114 estimates the internal resistance of the battery 10, based on the measured voltage and current, and determines deterioration of the battery 10 by comparing the estimated internal resistance with the threshold value. Here, the threshold value is a pre-set internal resistance value, and may be differently set according to characteristics, applications, or the like of a battery.

FIG. 3 is a circuit diagram for describing the battery monitoring apparatus 100 according to another embodiment.

Referring to FIG. 3, the battery 10 may be connected to the monitoring circuit 120. The monitoring circuit 120 includes a switch S turned on/off by the switching controller 111, an inductor L2 connected to one end of the switch S, a diode D1, a capacitor CL, and a resistor RL connected in parallel to the capacitor CL.

The inductor L2 performs a function of restricting a transient current peak from the battery 10. The diode D1 performs a reverse voltage prevention function. The capacitor CL performs a function of a load for generating a temporary transient response condition. The resistor RL connected in parallel to the capacitor CL performs a function of an initial discharge resistor of the capacitor CL.

FIGS. 4 to 6 illustrate examples of analyzing a transient response characteristic of the battery 10 shown in FIG. 3.

Referring to FIG. 4, when the switch S is in an off state, a battery voltage VB is uniformly maintained and a charging voltage VCL of the capacitor CL is discharged through the resistor RL, and thus becomes 0 V over time.

Referring to FIGS. 5 and 6, when a switch S transitions to an on state, a voltage of the capacitor CL slowly increases from 0 V and the capacitor CL is charged up to the battery voltage VB. Meanwhile, the battery voltage VB has a change in a voltage output in the form of a voltage drop, in proportion to a current output of a battery according to a transient input, with respect to the transient input for battery internal resistance changes Rs and Rp. A battery current decreases up to a capacitor charge completion time point after reaching a peak value at a time point when a battery voltage is the minimum.

Here, a change in internal resistance of the battery, i.e., a change that is a criterion for determining deterioration, may be divided into a direct current (DC) component and an alternating current (AC) component. The DC component is a series resistance component and the AC component is a component for a change in transfer characteristics of internal ions. As shown in FIG. 6, when the internal resistance of the battery is changed, a transient response (current/voltage) has changes in a peak value of a current and a voltage output. Accordingly, such an output pattern is measured and analyzed to diagnose a change in the internal resistance of the battery.

FIG. 7 is a circuit diagram for describing the battery monitoring apparatus 100 according to another embodiment.

Referring to FIG. 7, the circuit diagram is obtained by modeling the battery 10 to a battery equivalent circuit as below and combining the same to the monitoring circuit 120 of FIG. 4. Here, v and i respectively denote battery terminal voltage and current, and circuits for controlling a transient state are a switch device S (metal oxide semiconductor field-effect transistor (MOSFET)) and a resistance-capacitance (RC) load. Also, vj (j=0, 1, or 2) is an overpotential voltage over Rs, Rp, and L1. Here, Rs, Rp, and C1 represent components of a typical battery equivalent model, where they respectively denote the DC internal resistance, AC internal resistance, and battery capacity. Meanwhile, L1 also represents the inductance component caused by the battery structure, which influences the output voltage and current during very short transient periods, typically within a timescale of 1 ms. In a circuit model, the capacitor CL changes a voltage and current of a battery, including a transient state, while the capacitor CL is charged from a discharged state to a fully charged state, by controlling the switch S. In the transient state, a transient response of the battery may be represented in two modes as below. First, in mode 0, the switch S is in an off state, the capacitor CL is discharged through the resistor RL, and a potential VCL between terminals of the capacitor CL is maintained to 0 V. In mode 1, a state of the switch S is changed from off to on, and the battery starts charging by using the capacitor CL. Then, a charging current i(t) is changed until a potential VCL level is the same as the battery voltage VB.

Referring back to FIG. 7, a voltage of an RLC circuit according to a battery model, based on a time t, i.e., a battery internal voltage vi(t), is as Equations 1 and 2 below.

[Equation 1]

$$v_i(t) = v_0(t) + v_1(t) + v_2(t)$$

[Equation 2]

$$v_0(t) = i(t)R_S,\ v_1(t) = R_P i(t) e^{-\frac{t}{\tau}},\ v_2(t) = L_1 \frac{di}{dt}$$

Load-side potential vL changing according to the battery current i(t) is as Equations 3 and 4 below.

[Equation 3]

$$v_L(t) = v_3(t) + v_4(t)$$

[Equation 4]

$$v_3(t) = L_2 \frac{di}{dt},\ v_4(t) = \frac{1}{C_L} \int i dt$$

Accordingly, a change in an output terminal voltage VT of the battery in a transient state may be represented as Equations 5 and 6 below.

[Equation 5]

$$v_T(t+1) = v_B(0) - v_i(t) + v_L(t)$$

[Equation 6]

$$v_T(t+1) = v_B(0) - \left[\left(R_S + R_P e^{-\frac{t}{\tau}}\right) i(t) + L_1 \frac{di}{dt}\right] + L_2 \frac{di}{dt} + C_L \int i dt$$

$v_T$ : Terminal voltage of the battery (V)
$v_B$ : Voltage of the battery (V)
$L_1$ : Internal inductance of the battery (H)
$L_2$ : Load inductance (H)
$R_S$ : Ohmic resistance (Ohm)
$R_P$ : Polarization resistance (Ohm)
$C_L$ : Load capacitor (F)

FIGS. 8 to 12 are diagrams showing simulation results for describing a battery internal resistance.

A test process according to an embodiment may include a control circuit configured to generate a battery charging period, a discharging period, and a transient state for setting an open circuit voltage (OCV) condition of a battery, and a digital oscilloscope configured to measure a voltage and current of a battery terminal in the transient state.

As shown in FIG. 8, lithium ion battery samples used in the present test are commercial products used in an actual ESS field, and total three samples with aging degrees were used so as to test a change in internal impedance of a battery according to aging degrees. The three samples were aged under a battery module deterioration condition as below.

Two battery modules M1 and M2 were deteriorated for 300 cycles under a condition of a normal operating temperature of 23 °C and an acceleration aging temperature of 50 °C , and the remaining battery module M3 was deteriorated only for 1 cycle under a normal condition. An acceleration aging condition of a battery may be defined as Equation 7 below.

[Equation 7]

$$K_2 = K_1 \times exp\left[\frac{E_a}{K_a} \times \left(\frac{1}{T_1} - \frac{1}{T_1}\right)\right]$$

$K_1$ : Accelerated aging time (hour)
$K_2$ : Equivalent life (hour)
$T_1$ : Accelerated aging temperature (K)
$T_2$ : Operating temperature (K)
$E_a$ : Activation energy (eV)
$K_b$ : Boltzmann constant

A test procedure for measuring internal impedance of a commercial battery module is as follows. First, each battery module sample is charged under a same OCV condition. Then, discharging is performed until a next operation specified in the test procedure is reached, and internal impedance in an idle state and a voltage/current curve in a transient state through charging and discharging control to a capacitor load are measured in each operation specified in the test procedure.

An internal resistance obtained as a result of measuring each battery module is shown in FIG. 9. The internal resistance tends to increase in proportion to an aging degree of the battery. However, the width of a change in the internal resistance of each battery module varies according to OCV level conditions. Such a result indicates that online monitoring of the internal resistance is required for safety of the battery in all levels of state of charge (SOC).

As shown in FIG. 10, a change in a voltage peak in a normal operating state of each module increases in proportion to an internal impedance cause according to aging, under a same OCV level condition. Also, a change in a peak current output in a transient state is linearly proportional to an OCV level. Accordingly, normalization is required to extract internal resistance information for each OCV level by using measurement information of a voltage change and peak current in a transient state of a battery.

Normalization on a transient response characteristic of internal impedance of a battery may be defined as Equation 8 below.

[Equation 8]

$$R_{Normal}(\mathrm{OCV}) = \frac{\Delta V_{PEAK}(OCV)}{I_{PEAK}(OCV)}$$

Results of performing normalization on measurement data of three battery modules having different aging degrees as shown in FIGS. 11 and 12. FIG. 11 illustrates normalization results of peak currents (Ipeak) of battery modules under a transient condition according to OCV stages, and FIG. 12 illustrates normalization results of voltages and peak currents in a transient condition according to OCV stages. The results show that the normalization results of voltage and current measurement values according to a change in internal impedance of a lithium ion battery module are proportional to an aging degree of each battery module.

In a simulation according to an embodiment, simulation analysis using a battery circuit equivalent model is as follows. First, the battery circuit equivalent model including an internal inductance parameter is applied so as to analyze a transient response characteristic of an output of a lithium ion battery in a transient state according to a change in internal impedance of the lithium ion battery. As a parameter for battery internal resistance (Rs and Rp) applied to the battery circuit equivalent model, a value based on measurement results of three battery modules having different aging degrees, which were used in a measurement test, was used to compare a measurement result and a simulation result.

It was identified that the internal resistance increases in proportion to an aging state of each battery module, according to a result of measuring a change in the internal impedance according to the aging state of each commercial battery module. However, such a result showed that an internal impedance increase pattern varies according to an OCV level of a battery module. Thus, the result indicates that it is required to measure and analyze an entire operation range of a battery so as to monitor, through online, a change in internal impedance according to aging of the battery. Also, according to a result of simulation analysis using information about internal impedance measured for each battery module, it was identified that output characteristics of a voltage and current of a transient battery are very similar to those of a result of testing a commercial battery module.

Thus, a real-time battery monitoring apparatus and method, according to an embodiment, may measure internal impedance within hundreds of microseconds without having to temporarily stop a battery operation, and are very effective in monitoring, through online, a change in the internal impedance.

Although not illustrated, a real-time battery monitoring apparatus and method, according to an embodiment, may determine deterioration information of all battery cells of a battery or ESS, and then output an alarm indicating that a specific battery or a battery cell is deteriorated or display a warning on a display panel, for a user or a system operator to identify the deterioration information.

An apparatus according to an embodiment may include a processor, a memory storing and executing program data, a permanent storage such as a disk drive, a communication port configured to communicate with an external device, and a user interface device such as a touch panel, a key, or a button. Methods implemented by a software module or algorithm may be stored in a computer-readable recording medium as computer-readable codes or program instructions executable on the processor. Examples of computer-readable recording medium include magnetic storage media (for example, read-only memory (ROM), random-access memory (RAM), floppy disc, and hard disc) and optical reading media (for example, CD-ROM and digital versatile disk (DVD). The computer-readable recording medium may be distributed over a computer system connected through a network, and computer-readable codes may be stored and executed in a distributed manner. The medium is readable by a computer, stored in a memory, and may be executed in a processor.

Reference numerals are indicated in embodiments shown in the drawings, and specific terms are used to describe the embodiments. However, the present disclosure is not limited by the specific terms, and the embodiments may include all configurations that may be commonly thought of by one of ordinary skill in the art.

An embodiment may be represented by functional block configurations and various processing operations. The functional blocks may be implemented by various numbers of hardware and/or software configurations that perform particular functions. For example, an embodiment may employ integrated circuit configurations, such as memories, processors, logics, and look-up tables, which may execute various functions under control by one or more microprocessors or other control devices. Like components of the present disclosure being implemented by software programming or software elements, an embodiment may be implemented in programming or scripting language, such as C, C+, Java, or assembler, by including various algorithms implemented by a combination of data structures, processes, routines, or other programming configurations. Functional aspects may be implemented by algorithms executed in one or more processors. In addition, an embodiment may employ general techniques for electronic environment setting, signal processing, and/or data processing. The terms such as "mechanism", "element", "means", and "configuration" may be used widely and are not limited as mechanical and physical configurations. The terms may include a meaning of a series of routines of software in association with a processor or the like.

Certain executions described in an embodiment are embodiments and do not limit the scope of the embodiment in any way. For brevity of the specification, general electronic configurations, control systems, software, and other functional aspects of systems may be omitted. In addition, connection or connection members of lines between components shown in the drawings exemplarily represent functional connections and/or physical or circuit connections, and in an actual apparatus, may be replaced or may be implemented as various additional functional connections, physical connections, or circuit connections. Also, elements described herein may not be essential elements for application of the present disclosure unless the elements are particularly described as being "essential" or "critical".

The term "the" and similar referential terms in the specification (specifically in the claims) of an embodiment may be used for both the singular and the plural. Further, when a range is described in an embodiment, the present disclosure includes inventions to which individual values belonging to the range are applied (unless otherwise stated), and it is considered that each individual value configuring the range is described in the detailed description. Lastly, unless an order is clearly stated or unless otherwise stated, operations configuring a method according to an embodiment may be performed in an appropriate order. An embodiment is not necessarily limited by an order the operations are described. In an embodiment, the use of all examples or exemplary terms (for example, "etc.") is merely for describing the embodiment in detail and the scope of the embodiment is not limited by those examples or exemplary terms unless defined in the claims. Also, it would be obvious to one of ordinary skill in the art that various modifications, combinations, and changes may be configured according to design conditions and factors within the scope of claims or equivalents.

## Claims

**1.** A real-time battery monitoring apparatus comprising:

a monitoring circuit connected to a battery; and
a processor configured to determine deterioration of the battery by controlling the monitoring circuit to measure a voltage and a current of the battery, estimate an internal resistance of the battery, based on the measured voltage and current, and compare the estimated internal resistance with a pre-set threshold value.

**2.** The real-time battery monitoring apparatus of claim 1, wherein the monitoring circuit comprises:

a switch device connected to one end of the battery;
an inductor connected in series to one end of the switch device;
a diode connected in series to the inductor;
a capacitor connected in series to the diode; and
a resistor connected in parallel to the capacitor.

**3.** The real-time battery monitoring apparatus of claim 2, wherein the processor is further configured to:

discharge, by turning off the switch device, a voltage charged in the capacitor through the resistor;
charge the capacitor with power of the battery by turning on the switch device after a lapse of a predetermined time; and
measure the current and the voltage of the battery during a period of charging.

**4.** The real-time battery monitoring apparatus of claim 3, wherein the processor is further configured to:

estimate the internal resistance of the battery, based on changes in a peak value of the current and a peak value of the voltage;
normalize the internal resistance according to equation

[Equation]

$$R_{Normal}(\mathrm{OCV}) - \frac{\Delta V_{PEAK(OCV)}}{I_{PEAK(OCV)}};$$

and
when the normalized internal resistance is outside the threshold value, determine that the battery is deteriorated.

**5.** The real-time battery monitoring apparatus of claim 3, wherein a switching time including on and off of the switch is within several msec.

**6.** A control method for a real-time battery monitoring apparatus including a monitoring circuit connected to a battery, the control method comprising:

measuring a voltage and a current of the battery by controlling the monitoring circuit;
estimating an internal resistance of the battery based on the measured voltage and current; and
determining deterioration of the battery by comparing the estimated internal resistance with a pre-set threshold value.

**7.** The control method of claim 6, wherein the measuring comprises:

discharging, by turning off a switch device of the monitoring circuit, a voltage charged in a capacitor of the monitoring circuit through a resistor;
charging the capacitor with power of the battery by turning on the switch device after a lapse of a predetermined time; and
measuring the current and the voltage of the battery during a period of charging.

**8.** The control method of claim 7, further comprising:

estimating the internal resistance of the battery, based on changes in a peak value of the current and a peak value of the voltage;
normalizing the internal resistance according to equation

[Equation]

$$R_{Normal}(\mathrm{OCV}) = \frac{\Delta V_{PEAK(OCV)}}{I_{PEAK(OCV)}};$$

and
when the normalized internal resistance is outside the threshold value, determining that the battery is deteriorated.

**9.** The control method of claim 7, wherein a switching time including on and off of the switch is within several msec.

**10.** A computer-readable recording medium having recorded thereon a program for executing, on a computer, the control method for a real-time battery monitoring apparatus of claim 6.

FIG. 1

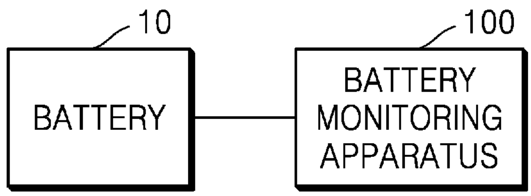

FIG. 2

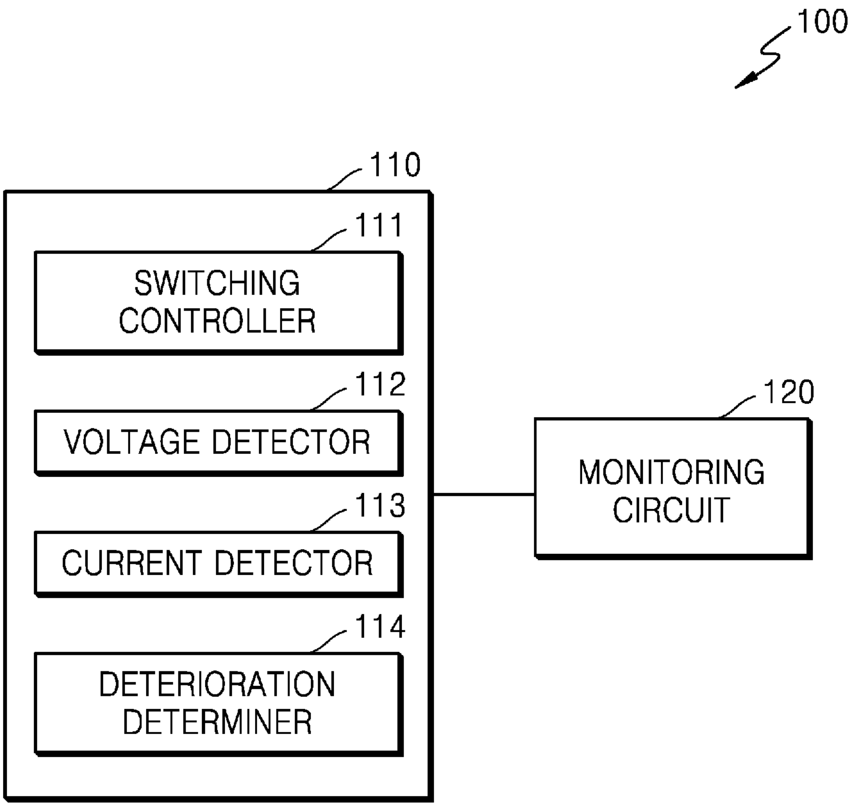
100
110
111
SWITCHING CONTROLLER
112
VOLTAGE DETECTOR
113
CURRENT DETECTOR
114
DETERIORATION DETERMINER
120
MONITORING CIRCUIT

FIG. 3

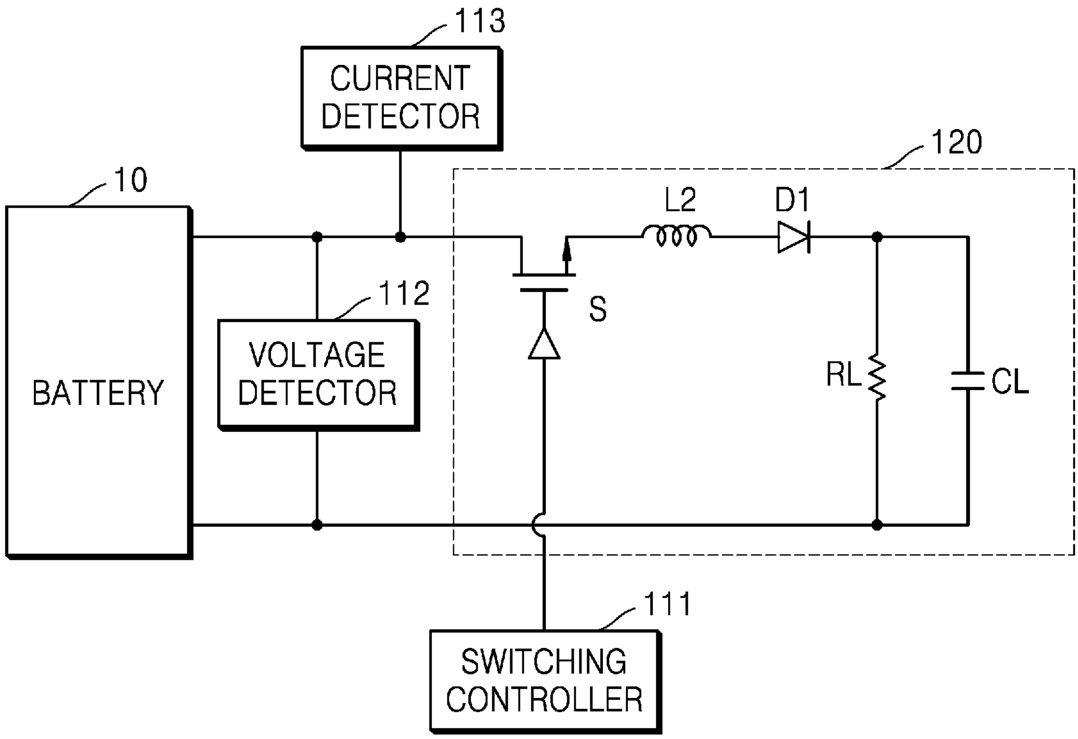
113
CURRENT DETECTOR
120
10
L2
D1
BATTERY
112
VOLTAGE DETECTOR
S
RL
CL
111
SWITCHING CONTROLLER

FIG. 4

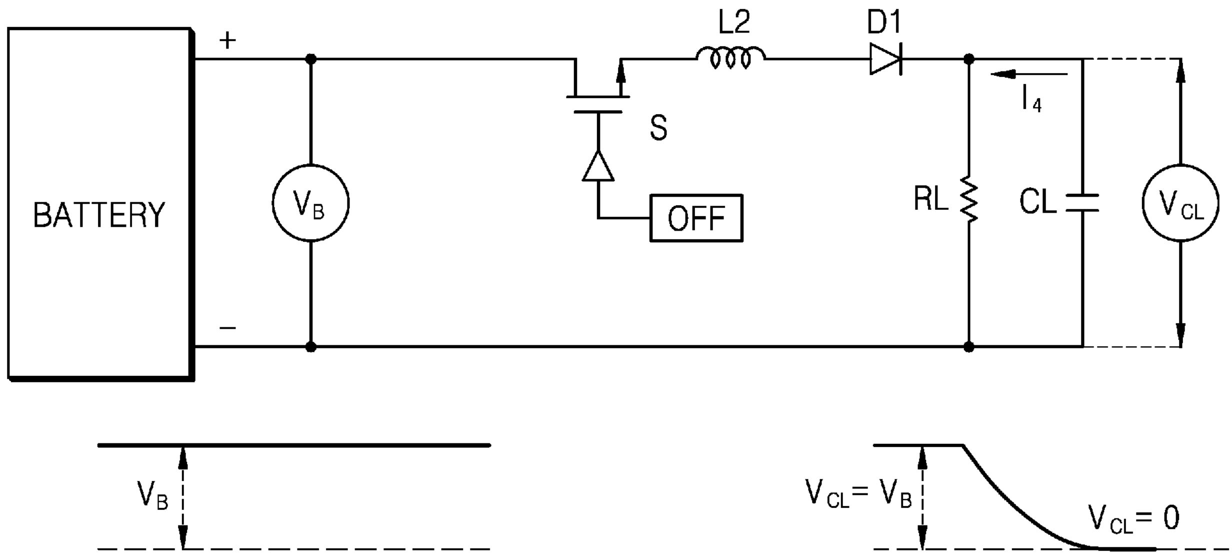

FIG. 5

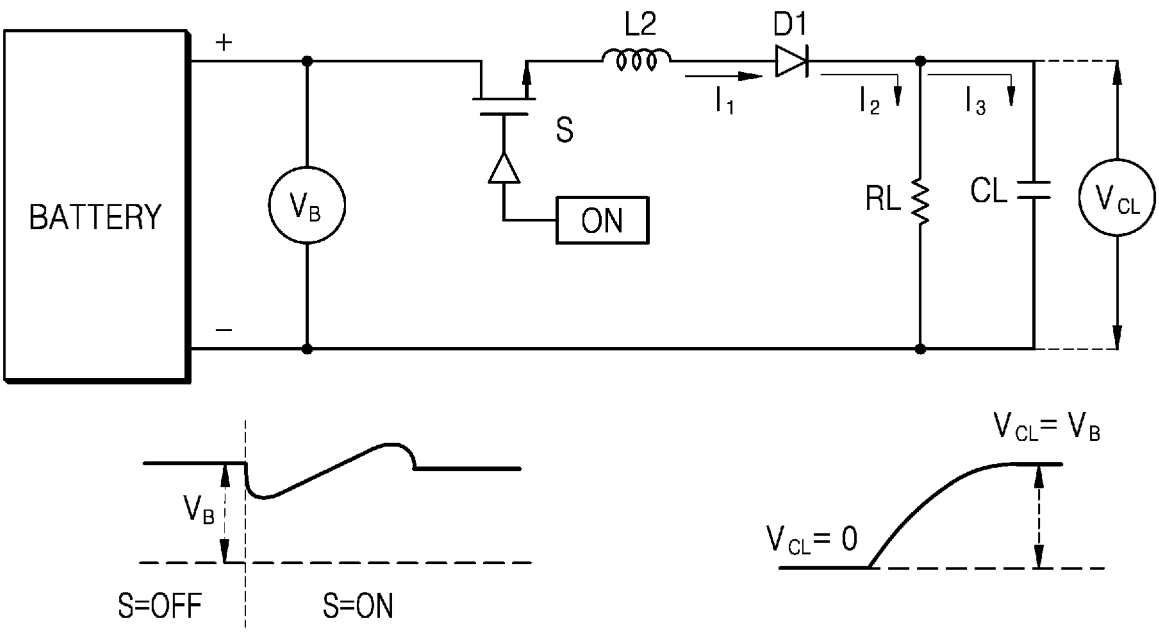

FIG. 6

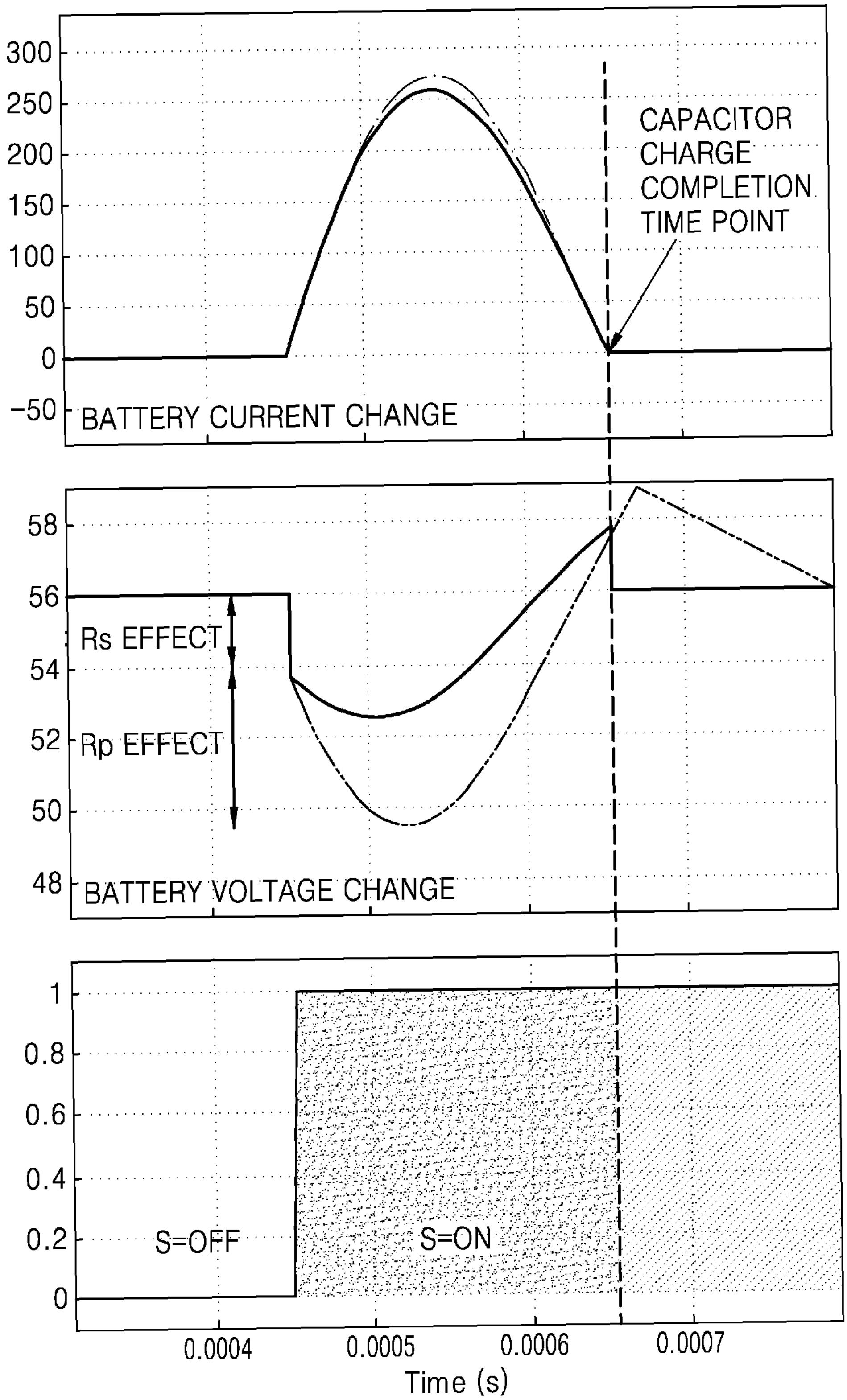
300
250
200
150
100
50
0
−50
BATTERY CURRENT CHANGE
CAPACITOR CHARGE COMPLETION TIME POINT
58
56
54
52
50
48
Rs EFFECT
Rp EFFECT
BATTERY VOLTAGE CHANGE
1
0.8
0.6
0.4
0.2
0
S=OFF
S=ON
0.0004
0.0005
0.0006
0.0007
Time (s)

FIG. 7

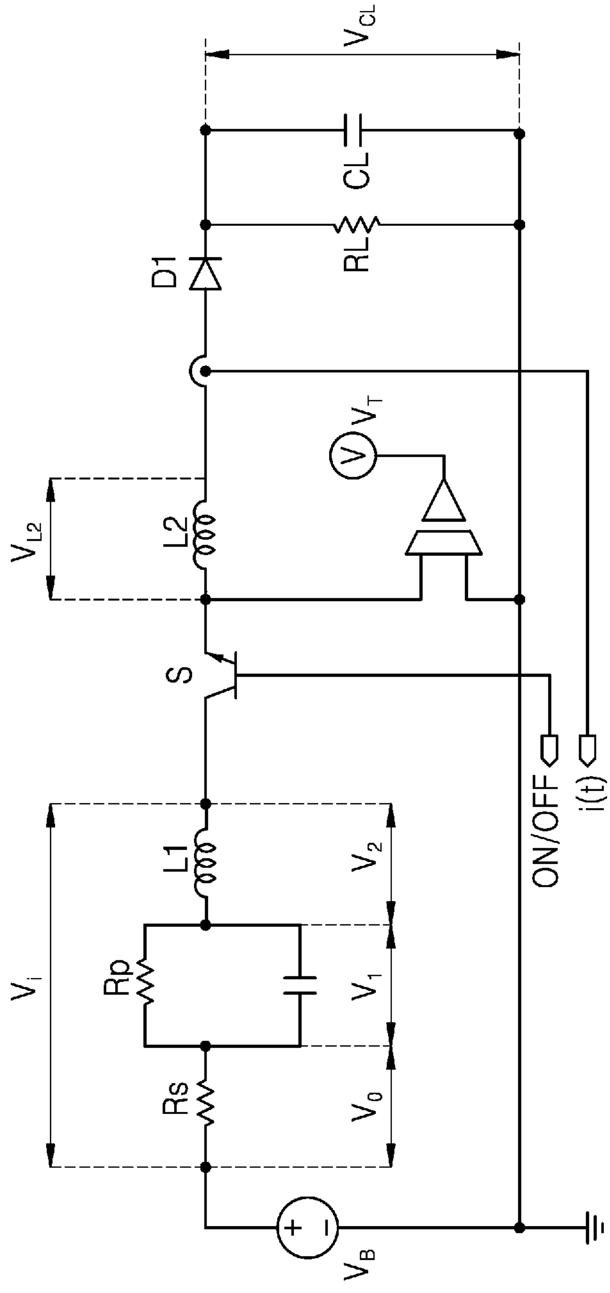
V<sub>CL</sub>
CL
RL
D1
V<sub>T</sub>
V
V<sub>L2</sub>
L2
S
ON/OFF
i(t)
L1
V<sub>2</sub>
V<sub>i</sub>
Rp
V<sub>1</sub>
Rs
V<sub>0</sub>
V<sub>B</sub>

FIG. 8

| # | Temp (Cycle) | Initial capacity [Ah] | SOH [%] | Remain capacity [Ah] | SOH [%] |
|---|---|---|---|---|---|
| BM1 | 23°C(300) | 57.6 | 91.5 | 56.4 | 89.5 |
| BM2 | 50°C(300) | 58.8 | 91.8 | 52.0 | 82.5 |
| BM3 | 23°C(1) | 57.7 | 91.6 | 57.7 | 91.6 |

FIG. 9

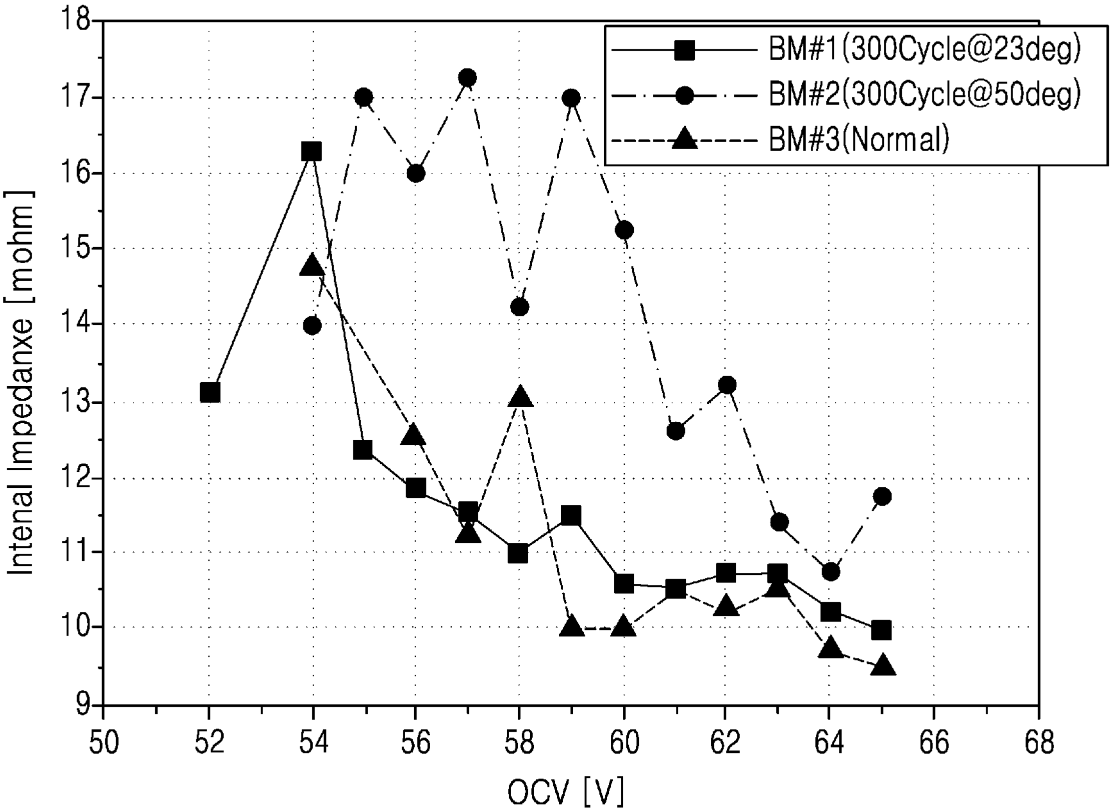
Intenal Impedanxe [mohm]
OCV [V]
BM#1(300Cycle@23deg)
BM#2(300Cycle@50deg)
BM#3(Normal)
18
17
16
15
14
13
12
11
10
9
50
52
54
56
58
60
62
64
66
68

FIG. 10

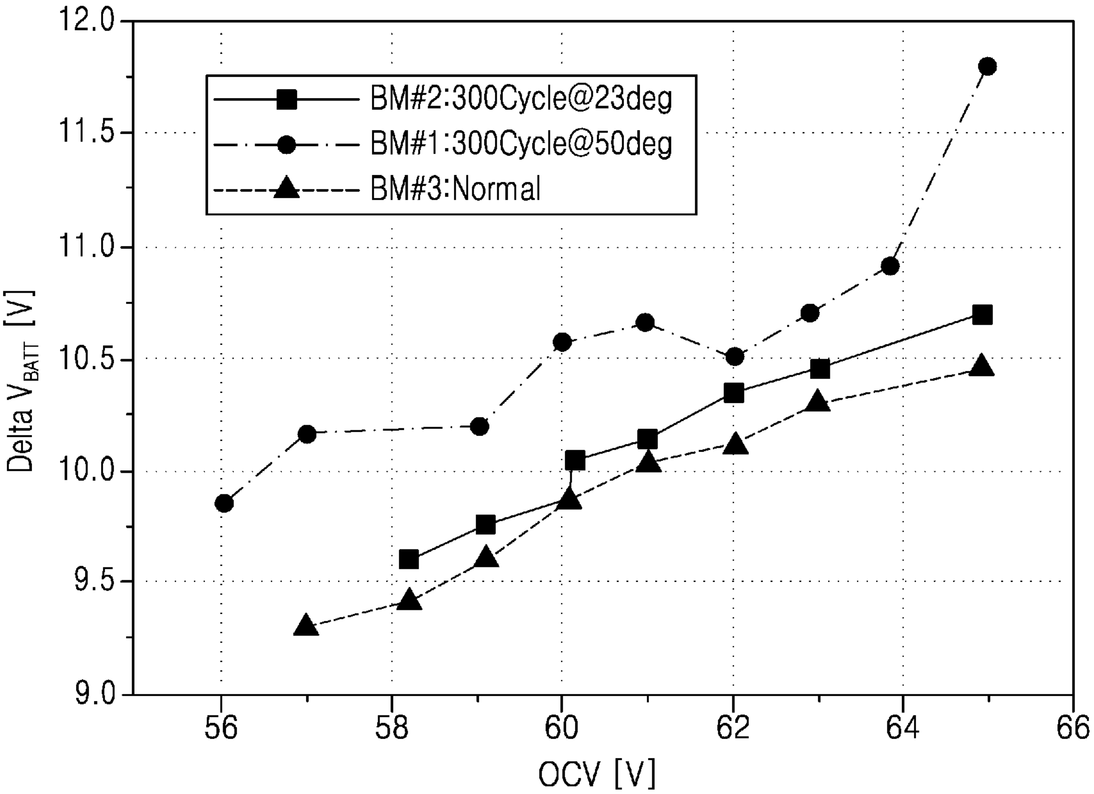
12.0
11.5
11.0
10.5
10.0
9.5
9.0
Delta $V_{BATT}$ [V]
56
58
60
62
64
66
OCV [V]
BM#2:300Cycle@23deg
BM#1:300Cycle@50deg
BM#3:Normal

FIG. 11

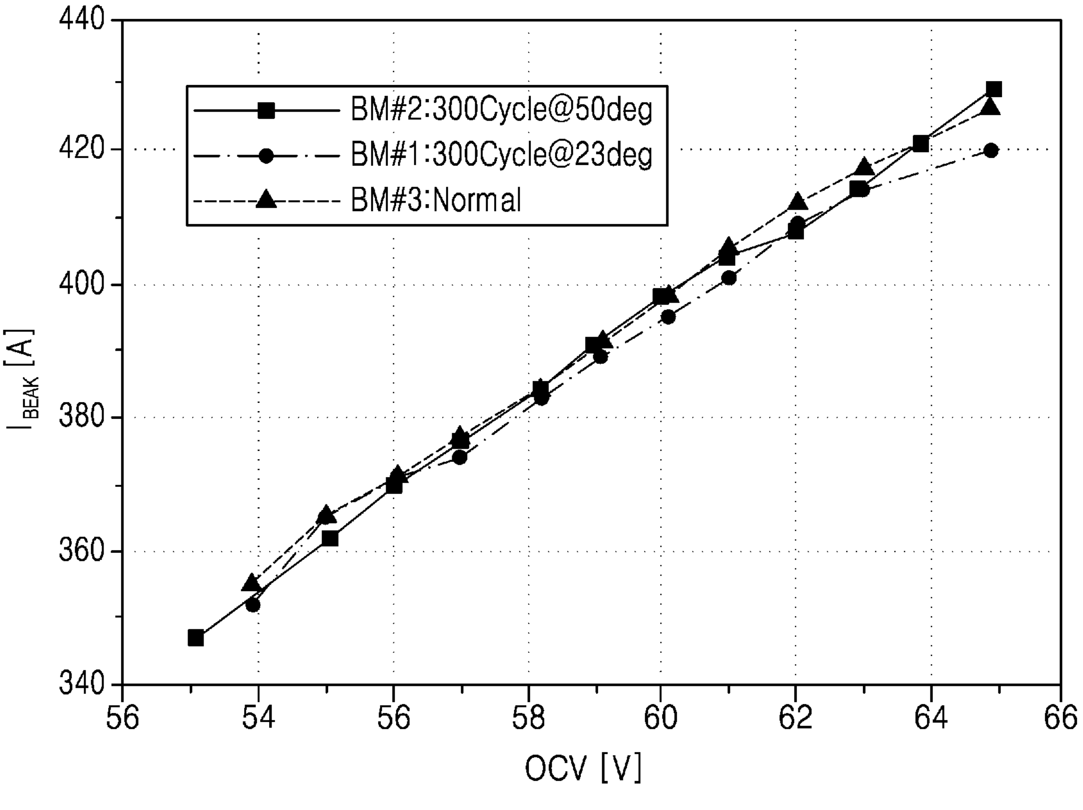

440
420
400
380
360
340
$I_{BEAK}$ [A]
56
54
56
58
60
62
64
66
OCV [V]
BM#2:300Cycle@50deg
BM#1:300Cycle@23deg
BM#3:Normal

FIG. 12

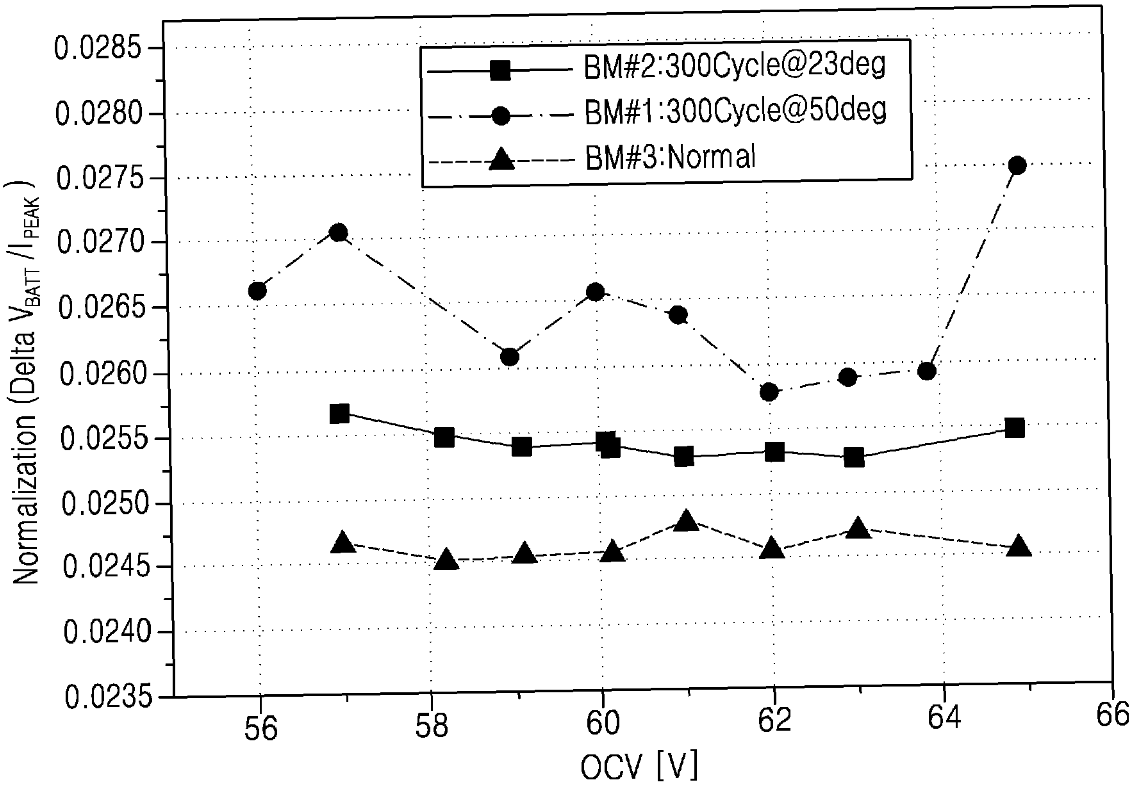
BM#2:300Cycle@23deg
BM#1:300Cycle@50deg
BM#3:Normal
Normalization (Delta $V_{BATT}$ /$I_{PEAK}$ )
0.0285
0.0280
0.0275
0.0270
0.0265
0.0260
0.0255
0.0250
0.0245
0.0240
0.0235
56
58
60
62
64
66
OCV [V]

**INTERNATIONAL SEARCH REPORT**

International application No.
**PCT/KR2022/012659**

**A. CLASSIFICATION OF SUBJECT MATTER**

**G01R 31/389**(2019.01)i; **G01R 31/392**(2019.01)i; **G01R 31/3842**(2019.01)i; **G01R 27/08**(2006.01)i; **H01M 10/48**(2006.01)i

According to International Patent Classification (IPC) or to both national classification and IPC

**B. FIELDS SEARCHED**

Minimum documentation searched (classification system followed by classification symbols)

G01R 31/389(2019.01); B60R 16/033(2006.01); G01R 31/36(2006.01); G01R 31/3835(2019.01); H01M 10/48(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 배터리(battery), 열화(degradation), 모니터링(monitoring), 내부 저항(internal resistance), 스위치(switch)

**C. DOCUMENTS CONSIDERED TO BE RELEVANT**

| Category* | Citation of document, with indication, where appropriate, of the relevant passages | Relevant to claim No. |
|---|---|---|
| X<br>A | KR 10-2015-0029204 A (SAMSUNG SDI CO., LTD.) 18 March 2015 (2015-03-18)<br>See paragraphs [0034]-[0042]; and figures 1-2. | 1,6,10<br>2-5,7-9 |
| X<br>A | KR 10-2017-0052937 A (YOUNG HWA TECH CO., LTD.) 15 May 2017 (2017-05-15)<br>See paragraphs [0021]-[0024]; and claim 1. | 1,6,10<br>2-5,7-9 |
| A | KR 10-2019-0095754 A (LG CHEM, LTD.) 16 August 2019 (2019-08-16)<br>See paragraphs [0010]-[0034]. | 1-10 |
| A | KR 10-2021-0011235 A (LG CHEM, LTD.) 01 February 2021 (2021-02-01)<br>See paragraphs [0005]-[0020]. | 1-10 |

☑ Further documents are listed in the continuation of Box C. ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **28 November 2022** | **28 November 2022** |
| Name and mailing address of the ISA/KR<br>**Korean Intellectual Property Office**<br>**Government Complex-Daejeon Building 4, 189 Cheongsa-ro, Seo-gu, Daejeon 35208**<br>Facsimile No. **+82-42-481-8578** | Authorized officer<br><br>Telephone No. |

Form PCT/ISA/210 (second sheet) (July 2022)

**INTERNATIONAL SEARCH REPORT**

International application No.
**PCT/KR2022/012659**

**C. DOCUMENTS CONSIDERED TO BE RELEVANT**

| Category* | Citation of document, with indication, where appropriate, of the relevant passages | Relevant to claim No. |
|---|---|---|
| A | US 2001-0034541 A1 (LYDEN, Michael J.) 25 October 2001 (2001-10-25)<br>See paragraphs [0015]-[0024]; and figures 1-2. | 1-10 |

Form PCT/ISA/210 (second sheet) (July 2022)

**INTERNATIONAL SEARCH REPORT**
**Information on patent family members**

International application No.
**PCT/KR2022/012659**

| Patent document cited in search report | Publication date (day/month/year) | Patent family member(s) | Publication date (day/month/year) |
|---|---|---|---|
| KR 10-2015-0029204 A | 18 March 2015 | CN 104426209 A | 18 March 2015 |
| | | EP 2846395 A2 | 11 March 2015 |
| | | EP 2846395 A3 | 25 March 2015 |
| | | JP 2015-052590 A | 19 March 2015 |
| | | US 2015-0070024 A1 | 12 March 2015 |
| KR 10-2017-0052937 A | 15 May 2017 | KR 10-1776844 B1 | 11 September 2017 |
| KR 10-2019-0095754 A | 16 August 2019 | CN 110709716 A | 17 January 2020 |
| | | CN 110709716 B | 28 December 2021 |
| | | EP 3674726 A1 | 01 July 2020 |
| | | EP 3674726 A4 | 16 December 2020 |
| | | JP 2020-524267 A | 13 August 2020 |
| | | JP 6844090 B2 | 17 March 2021 |
| | | KR 10-2373458 B1 | 10 March 2022 |
| | | US 11125823 B2 | 21 September 2021 |
| | | US 2020-0081066 A1 | 12 March 2020 |
| | | WO 2019-156377 A1 | 15 August 2019 |
| KR 10-2021-0011235 A | 01 February 2021 | None | |
| US 2001-0034541 A1 | 25 October 2001 | CA 2303095 A1 | 25 March 1999 |
| | | EP 1019742 A1 | 19 July 2000 |
| | | US 2002-0140404 A1 | 03 October 2002 |
| | | US 2004-0024426 A1 | 05 February 2004 |
| | | US 2004-0073264 A1 | 15 April 2004 |
| | | US 2007-0265672 A1 | 15 November 2007 |
| | | US 6167309 A | 26 December 2000 |
| | | US 6631293 B2 | 07 October 2003 |
| | | US 6654640 B2 | 25 November 2003 |
| | | US 7251527 B2 | 31 July 2007 |
| | | US 7515962 B2 | 07 April 2009 |
| | | US 7580749 B2 | 25 August 2009 |
| | | WO 99-14612 A1 | 25 March 1999 |

Form PCT/ISA/210 (patent family annex) (July 2022)